# FASCICULE DE BREVET EUROPEEN

(11) **EP 3 711 898 B1**
(45) Date de publication et mention de la délivrance du brevet: **20.10.2021**
(21) Numéro de dépôt: 20157814.3
(22) Date de dépôt: 18.02.2020
(51) Int. Cl.: B23P 23/04, B23P 15/00, F01D 5/34, F04D 29/26, F04D 29/08, F01D 5/06, F04D 19/02, F01D 11/02, F01D 11/00, F16J 15/44, F16J 15/447, B23Q 9/00, F01D 25/28, C23C 4/18, B05B 13/04, C23C 4/11, C23C 14/50, F04D 29/02, F04D 29/32, F04D 29/16, B05B 13/02

(54) **OUTILLAGE AMÉLIORÉ POUR LE REVÊTEMENT DE LÉCHETTES**
VERBESSERTES WERKZEUG ZUR BESCHICHTUNG VON DICHTUNGSLIPPEN
IMPROVED TOOL FOR COATING SEALS

(30) Priorité: 19.02.2019 FR 1901640
(43) Date de publication de la demande: 23.09.2020
(73) Titulaire: SAFRAN AIRCRAFT ENGINES, 75015 Paris (FR)
(72) Inventeur: DUDON, Laurent, Paul, 77550 MOISSY CRAMAYEL (FR); THIERCELIN, Mickaël, 77550 MOISSY CRAMAYEL (FR)
(74) Mandataire: Cabinet Beau de Loménie

(56) Documents cités:
- EP-A1- 1 291 494
- EP-A1- 3 017 898
- EP-A1- 3 427 892
- FR-A1- 3 050 671
- JP-A- 2017 013 140

## Description

### Domaine Technique

La présente invention concerne le domaine des turboréacteurs, et vise plus précisément la réalisation de pistes de matériau abradable pour turboréacteurs.

En particulier, la présente demande concerne un outillage pour le revêtement de léchettes et un procédé de formation d'un revêtement abradable pour des léchettes selon les préambules des revendications 1 et 7 respectivement. Un tel outillage et un tel procédé sont décrits dans le document FR 3 050 671 A1.

### Technique antérieure

Les turboréacteurs comprennent de manière connue des portions d'étanchéité désignées communément sous l'appellation de joints labyrinthes, de tels joints étant notamment avantageux pour la réalisation d'étanchéité entre des pièces tournantes. Les joints labyrinthes comprennent d'une part une piste en matériau abradable réalisée sur un composant, et d'autre part un ensemble de léchettes formées sur un autre composant et adaptées pour venir au contact de la piste en matériau abradable, ce contact réalisant une fonction d'étanchéité.

Lors du fonctionnement, le contact entre les léchette et la piste entraine une usure de la piste dans laquelle les léchettes viennent frotter. Un problème récurrent est le transfert du matériau abradable de la piste vers les léchettes, ainsi que l'usure du revêtement des léchettes, typiquement un matériau céramique.

La tenue à l'usure dépend notamment du procédé employé pour le dépôt du revêtement sur les léchettes. Le matériau céramique est typiquement projeté sur les léchettes. Un paramètre déterminant pour la tenue du revêtement est l'angle de projection. En effet, plus l'angle de projection est fermé, plus l'adhérence du matériau céramique est faible. De manière générale, une projection avec un angle de projection inférieure à 30° va entrainer une adhérence très faible, du fait de la formation de porosités en cheminées qui nuisent fortement à la cohésion du revêtement (on parle plus généralement de phénomène d'ombrage). Or, la géométrie des segments de rotors, et en particuliers des rotors munis d'aubes, est problématique pour la projection du revêtement et ne permet d'employer que des angles de projection très faibles, de l'ordre de 10°.

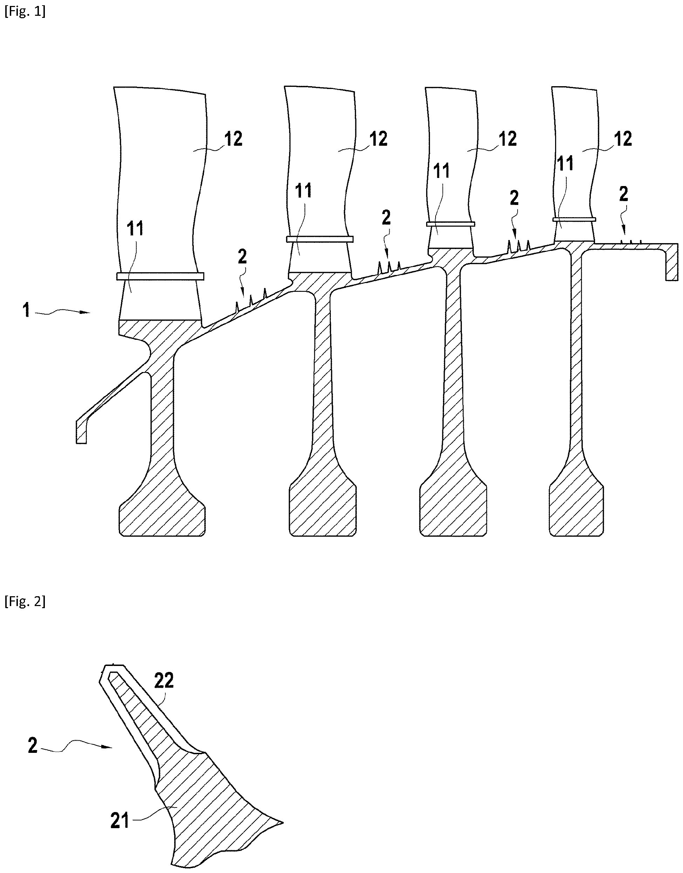

On représente sur la figure 1 un exemple de secteur de rotor 1 de turbomachine comprenant une pluralité de pieds d'aubes 11 entre lesquels sont positionnées des léchettes 2. Le secteur de rotor 1 est un secteur aubagé ; les pieds d'aubes 11 sont chacun associés à une aube 12 s'étendant radialement par rapport à un axe central (non représenté) du secteur de rotor 1. La figure 2 est une vue détaillée d'un exemple de léchette 2, sur laquelle on schématise le corps de léchette 21 et un revêtement 22 typiquement réalisé en matériau céramique.

On comprend aisément à la vue de la figure 1 que la présence des pieds d'aubes 11 et des aubes 12 limite les possibilités de projection du revêtement sur les léchettes 2.

### Exposé de l'invention

Afin de répondre au moins partiellement à ces problématiques, le présent exposé concerne un outillage pour le revêtement de léchettes d'un secteur de rotor de turbomachine, comprenant un support pour un secteur de rotor, un plateau de centrage adapté pour être inséré dans un secteur de rotor, ledit plateau de centrage présentant un logement central, un outil comprenant un bras de centrage, adapté pour être inséré dans le logement central du plateau de centrage, une torche, adaptée pour projeter un matériau céramique et un outil d'usinage, ledit outillage étant configuré de manière à positionner l'outil par rapport au secteur de rotor via le plateau de centrage, et à réaliser simultanément sur le secteur de rotor une projection de matériau céramique et un usinage sur deux secteurs distincts des léchettes.

Selon un exemple, la torche et l'outil d'usinage sont positionnés de part et d'autre du bras de centrage.

De manière optionnelle, le bras de centrage et le plateau de centrage comprennent des moyens de mise en rotation permettant la rotation relative du bras de centrage par rapport au plateau de centrage.

Le support est alors typiquement mobile en rotation par rapport à l'outil.

Selon un exemple, l'outil d'usinage et la torche sont chacun montés coulissant par rapport au bras de centrage.

L'outil d'usinage comprend par exemple une portion de coupe dont la forme correspond au négatif de léchettes à usiner.

Le présent exposé concerne également un procédé de formation d'un revêtement abradable pour des léchettes d'un secteur de rotor de turbomachine, dans lequel : on fournit un secteur de rotor de turbomachine comprenant une pluralité de léchettes, on positionne le secteur de rotor sur un support, on solidarise un plateau de centrage à une extrémité ouverte du secteur de rotor, l'extrémité opposée du secteur de rotor étant posée sur le support, ledit plateau de centrage présentant un logement central, on positionne un outil par rapport au secteur de rotor, en insérant un bras de centrage dans le logement central du plateau de centrage, ledit outil étant muni d'une torche et d'un outil d'usinage, on entraine en rotation le secteur de rotor par rapport à l'outil, on actionne la torche de manière à projeter un matériau céramique sur les léchettes du secteur de rotor, l'outil d'usinage étant positionné de manière à usiner lesdites léchettes en parallèle de la projection de matériau céramique par la torche.

De manière optionnelle, ledit procédé comprend en outre une étape dans laquelle on retire l'outil d'usinage, et on réalise une étape de projection de matériau céramique sur les léchettes.

### Brève description des dessins

L'invention et ses avantages seront mieux compris à la lecture de la description détaillée faite ci-après de différents modes de réalisation de l'invention donnés à titre d'exemples non limitatifs. Cette description fait référence aux pages de figures annexées, sur lesquelles :
[Fig. 1] La figure 1 décrite précédemment est une vue de secteur de rotor.
[Fig. 2] La figure 2 décrite précédemment est une vue détaillée du secteur de rotor de la figure 1.
[Fig. 3] La figure 3 représente schématiquement un outillage et un procédé selon un aspect de l'invention.
[Fig. 4] La figure 4 représente schématiquement un outillage et un procédé selon un aspect de l'invention.
[Fig. 5] La figure 5 représente schématiquement un outillage et un procédé selon un aspect de l'invention.

Sur l'ensemble des figures, les éléments en commun sont repérés par des références numériques identiques.

### Description des modes de réalisation

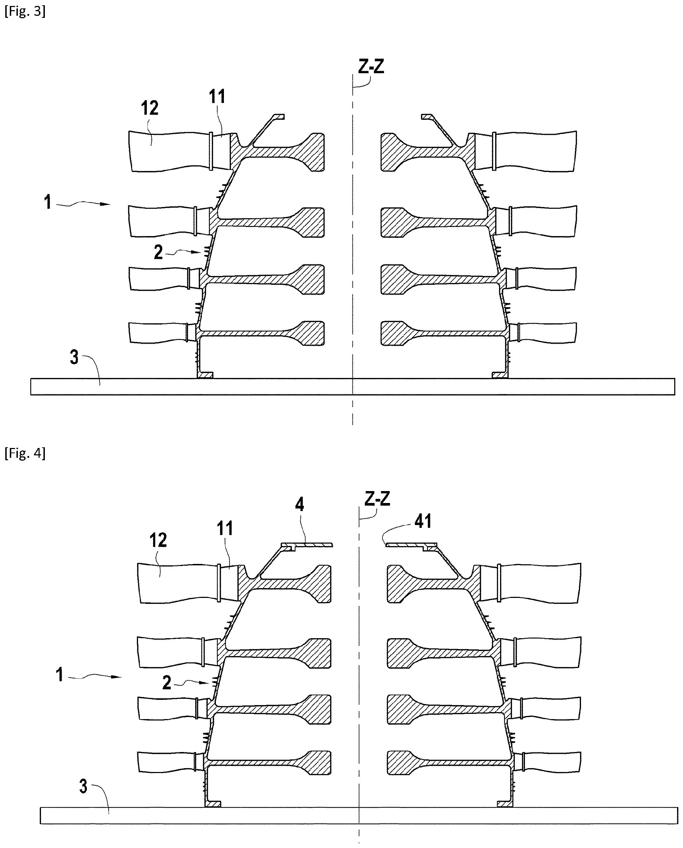

La figure 3, la figure 4 et la figure 5 représentent schématiquement un outillage et un procédé selon un aspect de l'invention, les différentes figures représentant les étapes successives d'un procédé selon l'invention.

On représente sur la figure 3 un secteur de rotor 1 de turbomachine comprenant une pluralité de pieds d'aubes 11, une pluralité d'aubes 12 ainsi qu'une pluralité de léchettes 2 disposées entre les pieds d'aubes 11 successifs. Lors d'une première étape, le secteur de rotor 1 est positionné sur un support 3 ; une extrémité du secteur de rotor 1 (par rapport à un axe central Z-Z du secteur de rotor 1) étant ainsi posée sur le support 3, son extrémité opposée étant alors libre. Les léchettes 2 sont typiquement similaires à celles déjà présentées en référence à la figure 2.

La figure 4 représente une étape suivante, dans laquelle on a positionné un plateau de centrage 4 sur l'extrémité libre du secteur de rotor 1.

Le plateau de centrage 4 est fixé à des brides du secteur de rotor 1, typiquement par boulonnage. Les brides du secteur de rotor 1 et des moyens de centrage du plateau de centrage 4 tels que des perçages assurent le positionnement, et notamment le centrage du plateau de centrage 4 par rapport au secteur de rotor 1. Le plateau de centrage 4 présente un logement central 41 adapté pour recevoir un bras de centrage que l'on décrira par la suite. Le logement central est typiquement aligné et coaxial par rapport à l'axe central Z-Z du secteur de rotor 1.

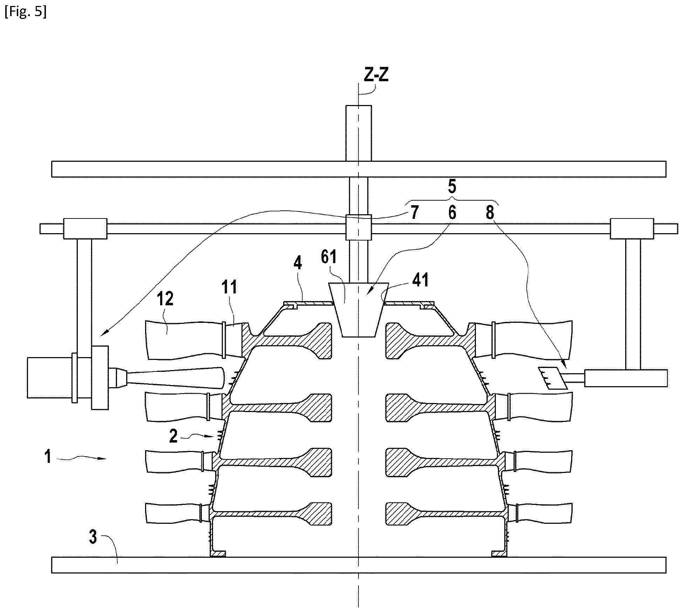

Dans une étape suivante schématisée sur la figure 5, on vient positionner un outil 5 par rapport au secteur de rotor 1.

L'outil 5 comprend un bras de centrage 6, une torche 7 et un outil d'usinage 8. L'outil 5 est solidaire d'un support fixe.

Le bras de centrage 6 présente une extrémité libre 61 adaptée pour venir s'insérer dans le logement central 41 du plateau de centrage 4.

Dans l'exemple illustré, le logement central 41 est un perçage tronconique traversant. L'extrémité libre 61 du bras de centrage 6 présente également une forme tronconique, ce qui permet un engagement et un centrage avec le perçage tronconique formant le logement central 41. On comprend que ce mode de réalisation n'est pas limitatif, et que l'extrémité libre 61 du bras de centrage 6 et le logement central 41 du plateau de centrage 4 peuvent prendre toute forme adaptée dès lors qu'ils permettent un engagement de l'outil 5 par rapport au plateau de centrage 4.

Le plateau de centrage 4 ou le bras de centrage 6 présente typiquement un élément permettant une rotation relative de ces deux éléments selon un axe correspondant à l'axe central Z-Z du secteur de rotor 1. A titre d'exemple, le plateau de centrage 4 ou le bras de centrage 6 peut présenter un roulement tel qu'un roulement à rouleaux qui assure une telle rotation relative du plateau de centrage 4 par rapport au bras de centrage 6. L'extrémité libre 61 du bras de centrage 6 peut par exemple être formée par un roulement conique ou tronconique qui assure à la fois un centrage et une telle possibilité de rotation selon l'axe de rotation du roulement, qui est alors avantageusement coaxial avec l'axe central Z-Z du secteur de rotor 1. En variante, le plateau de centrage 4 peut présenter un roulement (par exemple conique ou tronconique) au niveau de son logement central, dans lequel vient s'engager le bras de centrage 6.

Comme indiqué précédemment, l'outil 5 comprend une torche 7 et un outil d'usinage 8, qui sont chacun positionné sur un bras, s'étendant ici depuis le bras de centrage 6, lesdits bras étant réglables en hauteur (selon à l'axe central Z-Z) et en longueur (radialement par rapport à l'axe central Z-Z) afin d'assurer un bon positionnement par rapport au secteur de rotor 1.

La torche 7 réalise une projection de matériau céramique, afin de former un revêtement sur les léchettes 2 du secteur de rotor 1. Elle est typiquement positionnée sur un premier bras formant une portion mobile de l'outil 5, de manière à pouvoir être positionnée en face de léchettes 2 afin de réaliser une projection de matériau céramique. La torche 7 est ainsi typiquement mobile en translation selon une direction radiale par rapport à l'axe central Z-Z du secteur de rotor 1.

L'outil d'usinage 8 est positionné sur un second bras formant une portion mobile de l'outil 5 de manière à pouvoir être positionnée en face de léchettes 2 et réaliser un usinage des léchettes 2. L'outil d'usinage 8 est ainsi typiquement mobile en translation selon une direction radiale par rapport à l'axe central Z-Z du secteur de rotor 1. L'outil d'usinage 8 est typiquement associé à un système d'amortissement permettant de l'appliquer sur la pièce à usiner tout en évitant d'éventuels rebonds de l'outil d'usinage 8 sur le secteur de rotor 1 à usiner lors de sa rotation. Le système d'amortissement comprend typiquement des moyens de rappel tel qu'un ressort, calibré de manière à appliquer une pression d'usinage prédéterminée sur les léchettes 2.

L'outil d'usinage 8 présente typiquement une forme complémentaire à celle des léchettes 2 à usiner, la précision de l'outil d'usinage 8 conditionnant ainsi la précision de l'usinage réalisé.

L'outil d'usinage 8 et la torche 7 sont positionnés de manière à être en face de portions distinctes du secteur de rotor 1. Plus précisément, si on considère que le secteur de rotor 1 présente plusieurs ensembles distincts de léchettes, chaque léchette s'étendant sur toute la périphérie du secteur de rotor 1, alors l'outil d'usinage 8 et le torche 7 sont typiquement positionnés de manière à être simultanément en face d'un même ensemble de léchettes, mais selon deux secteurs angulaires distincts du secteur de rotor 1. Ainsi, la torche 7 peut réaliser une projection de matériau céramique sur un secteur angulaire d'une ou plusieurs léchettes, tandis que l'outil d'usinage 8 va usiner un autre secteur angulaire de cette ou de ces mêmes léchette(s). Les opérations d'usinage par l'outil d'usinage 8 et de projection par la torche 7 sont donc réalisées en simultané sur deux zones distinctes du secteur de rotor 1.

L'outil 5 est typiquement configuré de manière à ce que l'outil d'usinage 8 et la torche 7 soient positionnés de part et d'autre de l'axe central Z-Z du secteur de rotor 1, c'est-à-dire de part et d'autre d'un axe central du bras de centrage 6, ou encore formant un angle de 180° par rapport à l'axe central Z-Z lorsque le bras de centrage 6 est inséré dans le logement central 41 du plateau de centrage 4.

Ainsi, une fois l'outil 5 positionné par rapport au secteur de rotor 1, on réalise une étape de projection dans laquelle on réalise simultanément les opérations de projection du revêtement et d'usinage des léchettes 2. Le secteur de rotor 1 est alors entrainé en rotation, par rapport à l'outil 5, typiquement par le support 3, par exemple à une vitesse de l'ordre de 200 tours par minute. On peut alors piloter le déplacement radial de l'outil d'usinage 8 par rapport à l'axe central Z-Z afin de contrôler l'usinage.

De manière optionnelle, on réalise ensuite une opération additionnelle de projection de matériau céramique seule, sans opération d'usinage, afin de conférer une rugosité aux léchettes 2 équivalente à la rugosité obtenue au moyen d'un procédé conventionnel, ce qui permet d'assurer une bonne pénétration des léchettes 2 dans une piste en matériau abradable, présentant typiquement une structure en nid d'abeille. Cette étape peut par exemple être réalisée en rétractant l'outil d'usinage 8.

L'outillage et le procédé tels que présentés présentent ainsi plusieurs avantages par rapport aux outillages et procédés conventionnels.

En premier lieu, on comprend que l'outil 5 est ici positionné directement par rapport à la pièce, à savoir par rapport au secteur de rotor 1. Plus précisément, l'utilisation d'un plateau de centrage 4 qui est fixé au secteur de rotor 1 permet de réaliser un positionnement de l'outil 5 par rapport au secteur de rotor 1, contrairement aux outillages conventionnels dans lesquels l'outil est fixe et où on vient positionner la pièce par rapport à l'outil. Le fait de venir positionner l'outil 5 par rapport à la pièce 1 permet de s'affranchir des réglages de centrage de la pièce, le centrage étant ici effectué grâce à la coopération entre le plateau de centrage 4 et le bras de centrage 6.

Par ailleurs, le fait de réaliser simultanément les opérations de projection et d'usinage permet de prévenir ou à tout du moins de limiter la formation de porosités en cheminées. En effet, l'outil d'usinage 8 vient éroder le revêtement entre deux opérations de dépôt, ce qui empêche la formation de porosités en cheminées dans la mesure où les accumulations de revêtement sont alors érodées par l'outil d'usinage 8. L'outil d'usinage permet donc de remettre à niveau le revêtement entre chaque opération de dépôt de matière par la torche 7.

En outre, le fait de réaliser simultanément les opérations de projection et d'usinage permet de s'affranchir des opérations d'usinage ultérieures ; les léchettes 2 sont ici directement formées avec un revêtement à la cote souhaitée.

Bien que la présente invention ait été décrite en se référant à des exemples de réalisation spécifiques, il est évident que des modifications et des changements peuvent être effectués sur ces exemples sans sortir de la portée générale de l'invention telle que définie par les revendications. En particulier, des caractéristiques individuelles des différents modes de réalisation illustrés/mentionnés peuvent être combinées dans des modes de réalisation additionnels. Par conséquent, la description et les dessins doivent être considérés dans un sens illustratif plutôt que restrictif.

## Revendications

1. Outillage pour le revêtement de léchettes (2) d'un secteur de rotor (1) de turbomachine, comprenant un support (3) pour un secteur de rotor (1), un plateau de centrage (4) adapté pour être inséré dans un secteur de rotor (1), ledit plateau de centrage (4) présentant un logement central (41), un outil (5), **caractérisé par** ledit outil (5) comprenant un bras de centrage (6), adapté pour être inséré dans le logement central (41) du plateau de centrage (4), une torche (7), adaptée pour projeter un matériau céramique, un outil d'usinage (8), ledit outillage étant configuré de manière à positionner l'outil (5) par rapport au secteur de rotor (1) via le plateau de centrage (4), et à réaliser simultanément sur le secteur de rotor (1) une projection de matériau céramique et un usinage sur deux secteurs distincts des léchettes (2).

2. Outillage selon la revendication 1, dans lequel la torche (7) et l'outil d'usinage (8) sont positionnés de part et d'autre du bras de centrage (6).

3. Outillage selon l'une des revendications 1 ou 2, dans lequel le bras de centrage (6) et le plateau de centrage (4) comprennent des moyens de mise en rotation permettant la rotation relative du bras de centrage (6) par rapport au plateau de centrage (4).

4. Outillage selon la revendication 3, dans lequel le support (3) est mobile en rotation par rapport à l'outil (5).

5. Outillage selon l'une des revendications 1 à 4, dans lequel l'outil d'usinage (8) et la torche (7) sont chacun montés coulissant par rapport au bras de centrage (6).

6. Outillage selon l'une des revendications 1 à 5, dans lequel l'outil d'usinage (8) présente une portion de coupe dont la forme correspond au négatif de léchettes (2) à usiner.

7. Procédé de formation d'un revêtement abradable pour des léchettes (2) d'un secteur de rotor (1) de turbomachine, dans lequel :
- on fournit un secteur de rotor (1) de turbomachine comprenant une pluralité de léchettes (2),
- on positionne le secteur de rotor (1) sur un support (3),
- on solidarise un plateau de centrage (4) à une extrémité ouverte du secteur de rotor (1), l'extrémité opposée du secteur de rotor (1) étant posée sur le support (3), ledit plateau de centrage (4) présentant un logement central (41), **caractérisé en ce que**
- on positionne un outil (5) par rapport au secteur de rotor (1), en insérant un bras de centrage (6) dans le logement central (41) du plateau de centrage (4), ledit outil (5) étant muni d'une torche (7) et d'un outil d'usinage (8),
- on entraine en rotation le secteur de rotor (1) par rapport à l'outil (5),
- on actionne la torche (7) de manière à projeter un matériau céramique sur les léchettes (2) du secteur de rotor (1), l'outil d'usinage (8) étant positionné de manière à usiner lesdites léchettes (2) en parallèle de la projection de matériau céramique par la torche (7).

8. Procédé selon la revendication 7, comprenant en outre une étape dans laquelle on retire l'outil d'usinage (8), et on réalise une étape de projection de matériau céramique sur les léchettes (2).

## Patentansprüche

1. Werkzeuganordnung für die Beschichtung von Dichtlippen (2) eines Rotorsektors (1) einer Turbomaschine, umfassend einen Träger (3) für einen Rotorsektor (1), eine Zentrierplatte (4), die in einen Rotorsektor (1) eingeführt werden kann, wobei die Zentrierplatte (4) eine zentrale Aufnahme (41) aufweist; ein Werkzeug (5), **dadurch gekennzeichnet, dass** das Werkzeug (5) einen Zentrierarm (6) umfasst, der in die zentrale Aufnahme (41) der Zentrierplatte (4) eingeführt werden kann, einen Brenner (7), der ein keramisches Material auswerfen kann, ein Bearbeitungswerkzeug (8), wobei die Werkzeuganordnung dafür konfiguriert ist, das Werkzeug (5) über die Zentrierplatte (4) in Bezug auf den Rotorsektor (1) zu positionieren und gleichzeitig an dem Rotorsektor (1) ein Aufsprühen keramischen Materials und eine Bearbeitung an zwei getrennten Bereichen der Dichtlippen (2) vorzunehmen.

2. Werkzeuganordnung nach Anspruch 1, wobei der Brenner (7) und das Bearbeitungswerkzeug (8) auf gegenüberliegenden Seiten des Zentrierarms (6) angeordnet sind.

3. Werkzeuganordnung nach einem der Ansprüche 1 oder 2, wobei der Zentrierarm (6) und die Zentrierplatte (4) Drehmittel umfassen, die die relative Drehung des Zentrierarms (6) zur Zentrierplatte (4) ermöglichen.

4. Werkzeuganordnung nach Anspruch 3, wobei der Träger (3) relativ zum Werkzeug (5) drehbar ist.

5. Werkzeuganordnung nach einem der Ansprüche 1 bis 4, wobei das Bearbeitungswerkzeug (8) und der Brenner (7) jeweils in Bezug auf den Zentrierarm (6) verschiebbar montiert sind.

6. Werkzeuganordnung nach einem der Ansprüche 1 bis 5, wobei das Bearbeitungswerkzeug (8) einen Schneidteil aufweist, dessen Form dem Negativ der zu bearbeitenden Dichtlippen (2) entspricht.

7. Verfahren zur Herstellung einer abschleifbaren Beschichtung für Dichtlippen (2) eines Rotorsektors (1) einer Turbomaschine, wobei:
- ein Rotorsektor (1) einer Turbomaschine mit einer Vielzahl von Dichtlippen (2) bereitgestellt wird,
- der Rotorsektor (1) wird auf einem Träger (3) positioniert wird,
- eine Zentrierplatte (4) an einem offenen Ende des Rotorsektors (1) angebracht wird, wobei das gegenüberliegende Ende des Rotorsektors (1) auf dem Träger (3) angeordnet ist, wobei die Zentrierplatte (4) eine zentrale Aufnahme (41) aufweist;
**dadurch gekennzeichnet, dass**
- ein Werkzeug (5) in Bezug auf den Rotorsektor (1) positioniert wird, indem ein Zentrierarm (6) in die mittlere Aufnahme (41) der Zentrierplatte (4) eingeführt wird, wobei das Werkzeug (5) mit einem Brenner (7) und einem Bearbeitungswerkzeug (8) ausgestattet ist;
- der Rotorsektor (1) in Bezug auf das Werkzeug (5) gedreht wird,
- der Brenner (7) derart betätigt wird, dass er ein keramisches Material auf die Dichtlippen (2) des Rotorsektors (1) auswirft, wobei das Bearbeitungswerkzeug (8) derart positioniert ist, dass es die Dichtlippen (2) parallel zum Aufsprühen des keramischen Materials durch den Brenner (7) bearbeitet.

8. Verfahren nach Anspruch 7, das weiter einen Schritt umfasst, bei dem das Bearbeitungswerkzeug (8) entfernt wird, und wobei ein Schritt des Aufsprühens von keramischem Material auf die Dichtlippen (2) durchgeführt wird.

## Claims

1. A tooling for the coating of lips (2) of a turbomachine rotor sector (1), comprising a support (3) for a rotor sector (1), a centering plate (4) adapted to be inserted into a rotor sector (1), said centering plate (4) having a central housing (41), a tool (5), **characterized by** said tool (5) comprising a centering arm (6), adapted to be inserted into the central housing (41) of the centering plate (4), a torch (7), adapted to spray a ceramic material, a machining tool (8), said tooling being configured so as to position the tool (5) relative to the rotor sector (1) via the centering plate (4), and to simultaneously perform on the rotor sector (1) a spraying of ceramic material and a machining on two distinct sectors of the lips (2).

2. The tooling according to claim 1, wherein the torch (7) and the machining tool (8) are positioned on either side of the centering arm (6).

3. The tooling according to any of claims 1 or 2, wherein the centering arm (6) and the centering plate (4) comprise rotating means allowing the relative rotation of the centering arm (6) relative to the centering plate (4).

4. The tooling according to claim 3, wherein the support (3) is movable in rotation relative to the tool (5).

5. The tooling according to any of claims 1 to 4, wherein the machining tool (8) and the torch (7) are each slidably mounted relative to the centering arm (6).

6. The tooling according to any of claims 1 to 5, wherein the machining tool (8) has a cutting portion whose shape corresponds to the negative of lips (2) to be machined.

7. A method for forming an abradable coating for lips (2) of a turbomachine rotor sector (1), wherein:
- a turbomachine rotor sector (1) comprising a plurality of lips (2) is provided,
- the rotor sector (1) is positioned on a support (3),
- a centering plate (4) is secured to an open end of the rotor sector (1), the opposite end of the rotor sector (1) being placed on the support (3), said centering plate (4) having a central housing (41), **characterized in that**
- a tool (5) is positioned relative to the rotor sector (1), by inserting a centering arm (6) in the central housing (41) of the centering plate (4), said tool (5) being provided with a torch (7) and a machining tool (8),
- the rotor sector (1) is driven in rotation relative to the tool (5),
- the torch (7) is actuated so as to spray a ceramic material on the lips (2) of the rotor sector (1), the machining tool (8) being positioned so as to machine said lips (2) in parallel of the spraying of ceramic material by the torch (7).

8. The method according to claim 7, further comprising a step in which the machining tool (8) is removed, and a step of spraying ceramic material onto the lips (2) is carried out.
